# EUROPÄISCHE PATENTANMELDUNG

(11) **EP 2 456 293 A2**
(43) Veröffentlichungstag der Anmeldung: **23.05.2012**
(21) Anmeldenummer: 11182403.3
(22) Anmeldetag: 22.09.2011
(51) Int. Cl.: H05K 7/20

(54) **Kühlanordnung und Arbeitsverfahren für eine Lüftersteuerung**

(30) Priorität: 19.11.2010 DE 102010051962
(71) Anmelder: Fujitsu Technology Solutions Intellectual Property GmbH, 80807 München (DE)
(72) Erfinder: Scheidler, Gerold, 33181 Bad Wünnenberg (DE)
(74) Vertreter: Epping - Hermann - Fischer

(57) **Zusammenfassung**

Die Erfindung betrifft eine Kühlanordnung für ein Serverrack aufweisend ein Gehäuse mit einer Mehrzahl von Einschubpositionen (4) zur Aufnahme von Einschubkomponenten (3), wenigstens einer Ablufteinheit (9) zum Absaugen von durch elektrische oder elektronische Bauteile der Einschubkomponenten (3) erwärmter Luft und wenigstens eine Kühleinheit (11) zum Abkühlen der zur Kühlung verwendeten Luft.

Die Erfindung betrifft des Weiteren ein Arbeitsverfahren für eine Lüftersteuerung einer Kühlanordnung mit einer Ablufteinheit (9) zum Absaugen von durch elektrische oder elektronische Bauteile des Serverracks erwärmter Luft und wenigstens einer Kühleinheit (11) zum Kühlen der verwendeten Luft.

## Beschreibung

Die Erfindung betrifft eine Kühlanordnung aufweisend ein Gehäuse mit einer Mehrzahl von Einschubpositionen zur Aufnahme von Einschubkomponenten. Die Erfindung betrifft des Weiteren ein Arbeitsverfahren für eine Lüftersteuerung einer Kühlanordnung.

Kühlanordnungen aufweisend ein Gehäuse mit einer Mehrzahl von Einschubpositionen zur Aufnahme von Einschubkomponenten sind aus dem Stand der Technik bekannt. Beispielsweise ist aus der DE 202010007046 U1 ein Rackgehäuse umfassend eine Mehrzahl von Einschubpositionen zur Aufnahme einer Mehrzahl von lüfterlosen Einschubkomponenten in einem an eine erste Gehäuseseite angrenzenden ersten Bereich des Rackgehäuses bekannt. Das Rackgehäuse umfasst wenigstens eine Unterdruckkammer in einem an den ersten Bereich angrenzenden zweiten Bereich des Rackgehäuses, wobei zwischen der Unterdruckkammer und den Einschubpositionen erste Öffnungen vorgesehen sind, die eine Abfuhr von durch die Einschubkomponenten erwärmter Luft in die Unterdruckkammer ermöglichen. Die bekannte Kühlanordnung umfasst des Weiteren eine Ablufteinheit zur Erzeugung eines Unterdrucks in der Unterdruckkammer des Rackgehäuses.

Diesen und ähnlichen Kühlanordnungen liegt das folgende Funktionsprinzip zugrunde. Durch einen oder mehrere, verhältnismäßig leistungsstarke Lüfter wird Umgebungsluft durch die einzelnen Einschubkomponenten gesaugt oder geblasen, um eine Kühlung der darauf oder darin angeordneten elektrischen oder elektronischen Bauteile zu bewirken. Die erwärmte Luft wird dann entweder direkt nach außen abgeführt, beispielsweise über eine Ventilationseinrichtung einer Gebäudeinstallation, oder zurück in einen Betriebsraum geblasen, wobei hier oftmals eine zusätzliche Kühlung des Raums durch Klimaanlagen oder ähnliche Geräte sichergestellt werden muss.

Insbesondere bei mit besonders hochleistungsfähigen Einschubservern bestückten Serverracks entfällt ein erheblicher Teil der zu ihrem Betrieb erforderlichen Leistung entweder direkt oder mittelbar auf deren Kühlung.

Ein Problem bekannter Kühlanordnungen besteht darin, dass die verschiedenen Funktionseinheiten, insbesondere Einschubkomponenten, Gehäuse, Ablufteinheit und gegebenenfalls eine vorhandene Kühleinheit von unterschiedlichen Herstellern bereitgestellt werden und daher auch unabhängig voneinander optimiert werden. Beispielsweise nimmt der Wirkungsgrad von Wärmetauschern bei bekannten Anordnungen mit einer höheren Umgebungstemperatur zu, so dass deren Hersteller zum Betrieb bei einer verhältnismäßig hohen Umgebungstemperatur raten. Dies ist aber nachteilig für andere Funktionseinheiten, insbesondere in den Einschubkomponenten angeordnete Halbleiterbauteile.

Aufgabe der vorliegenden Erfindung ist es, die Energieeffizienz von Kühlanordnungen zu verbessern.

Gemäß einem ersten Aspekt der Erfindung wird ein Arbeitsverfahren für eine Lüftersteuerung einer Kühlanordnung mit wenigstens einer Ablufteinheit zum Absaugen von durch elektrische oder elektronische Bauteile einer Mehrzahl von Einschubkomponenten erwärmte Luft und wenigstens einer Kühleinheit zum Kühlen der zur Kühlung verwendeten Luft beschrieben. Das Arbeitsverfahren weist die folgenden Schritte auf:
- Bestimmen einer optimierten ersten Temperaturdifferenz für die zur Kühlung des Serverracks verwendeten Luft unter Berücksichtigung der Energieaufnahme der wenigstens einen Ablufteinheit und der wenigstens einen Kühleinheit in Abhängigkeit der Temperaturdifferenz und
- Messen wenigstens einer tatsächlichen Temperaturdifferenz zwischen wenigstens zwei Temperaturen der zur Kühlung verwendeten Luft; und
- Regeln einer Lüfterdrehzahl für die wenigstens eine Ablufteinheit in Abhängigkeit einer Abweichung zwischen der bestimmten optimierten Temperaturdifferenz und der gemessenen tatsächlichen Temperaturdifferenz.

Durch die oben genannten Schritte können zumindest die Energieaufnahme einer Ablufteinheit und einer Kühleinheit in Abhängigkeit einer Temperaturdifferenz des verwendeten Kühlmittels gemeinsam für eine Lüftersteuerung berücksichtigt werden. In dessen Folge kann durch Ansteuerung der Lüftereinheit ein Luftstrom durch die Mehrzahl von Einschubkomponenten zu deren Kühlung erzeugt werden, bei dem die Kombination der Ablufteinheit und der Kühleinheit insgesamt einen möglichst geringen Energiebedarf bzw. einen möglichst großen Wirkungsgrad aufweist.

Gemäß einer vorteilhaften Ausgestaltung wird im Schritt des Messens wenigstens eine Temperatur der zur Kühlung verwendeten Luft vor und nach einem Durchströmen der elektrischen oder elektronischen Bauteile gemessen. Durch die Messung der Temperaturdifferenz der durch die Bauteile erwärmten Luft kann ein geschlossener Regelkreis für die Lüftersteuerung aufgebaut werden.

Gemäß einer weiteren vorteilhaften Ausgestaltung wird im Schritt des Messens wenigstens eine zweite Temperaturdifferenz der zur Kühlung verwendeten Luft vor und nach einem Durchströmen der Kühleinheit gemessen. Durch die Berücksichtigung einer Temperaturdifferenz der durch die Ablufteinheit abgekühlten Luft kann unter anderem die Auswirkung der Lüftersteuerung auf den Aufstellungsort des Serverracks berücksichtigt werden. Beispielsweise kann sichergestellt werden, dass das Serverrack bezüglich seiner Umgebung temperaturneutral ist, das heißt die zur Kühlung verwendete Luft mit derselben Temperatur wieder abgibt, wie diese zuvor aufgenommen wurde.

Gemäß einem zweiten Aspekt der vorliegenden Erfindung wird eine Kühlanordnung, aufweisend ein Gehäuse mit einer Mehrzahl von Einschubpositionen zur Aufnahme von Einschubkomponenten, wenigstens eine Ablufteinheit zum Absaugen von durch elektrische oder elektronische Bauteile der Einschubkomponenten erwärmte Luft, und wenigstens eine Kühleinheit zum Abkühlen der zur Kühlung verwendeten Luft beschrieben. Die Kühlanordnung ist dadurch gekennzeichnet, dass die Kühleinheit in Strömungsrichtung vor der Mehrzahl der Einschubpositionen angeordnet ist, so dass in den Einschubpositionen angeordnete Einschubkomponenten mit gegenüber einer Temperatur einer bereitgestellten Luft abgekühlter Luft angeströmt werden.

Die Anordnung einer Kühleinheit in Strömungsrichtung vor einer Mehrzahl von Einschubpositionen weist den Vorteil auf, dass beim Betrieb der elektrischen oder elektronischen Bauteile der Einschubkomponenten eine geringere Verlustleistung anfällt. Dies liegt unter anderem daran, dass insbesondere Halbleiterkomponenten, wie sie vielfach in Computeranordnungen Verwendung finden, Leckstromverluste aufweisen, die mit steigender Temperatur ansteigen. Wird die zur Kühlung verwendete Luft erst abgekühlt, dann zur Kühlung der Einschubkomponenten verwendet und nachfolgend wieder abgegeben, sinkt daher die Verlustleistung der eingesetzten Einschubkomponenten bei einer im Wesentlichen Beibehaltung der zur Kühlung der Luft eingesetzten Energie ab.

Gemäß einer vorteilhaften Ausgestaltung bildet die Kühlanordnung ein offenes Kühlsystem, bei dem Luft aus einer Umgebung des Gehäuses im Bereich der Kühleinheit angesaugt und durch die Ablufteinheit an die Umgebung abgegeben wird. Eine derartige Kühlanordnung benötigt kein gesondertes Ventilationssystem am Ort ihrer Aufstellung.

Gemäß einer vorteilhaften Ausgestaltung weist die wenigstens eine Kühleinheit einen Wärmetauscher auf, wobei der Wärmetauscher die von der Kühleinheit entnommene Wärmeenergie an ein flüssiges Kühlmedium überträgt. Die Verwendung eines Wärmetauschers erlaubt eine besonders effiziente Abführung der Wärmeenergie aus der Kühlanordnung und beispielsweise die energetisch günstige Einspeisung in ein Heizungssystem einer Gebäudeinstallation.

Gemäß einer weiteren vorteilhaften Ausgestaltung ist das Gehäuse als Rackgehäuse für ein Serverrack mit der Mehrzahl von Einschubpositionen zur Aufnahme einer Mehrzahl von Einschubservern ausgebildet. Dabei weist das Rackgehäuse eine für alle Einschubpositionen zentrale Kühlluftführung auf, die mindestens jeweils eine Öffnung zum Absaugen der erwärmten Luft aus den Einschubpositionen mit der wenigstens einen Ablufteinheit verbindet. Durch die Verwendung einer zentralen Kühlluftführung kann der Aufbau und die Steuerung der Kühlanordnung und insbesondere der Ablufteinheit vereinfacht werden.

Gemäß einer vorteilhaften Ausgestaltung weist die zentrale Kühlluftführung eine Unterdruckkammer auf, wobei die wenigstens eine Ablufteinheit dazu eingerichtet ist, einen gegenüber einem Umgebungsluftdruck reduzierten Unterdruck in der Unterdruckkammer herzustellen. Eine derartige Anordnung erlaubt eine sichere Kühlung von lüfterlosen Einschubkomponenten.

Gemäß einer weiteren Ausgestaltung ist die Kühleinheit an oder anstelle einer vor der Mehrzahl von Einschubpositionen angeordneten Gehäusetür angeordnet. Die Anordnung der Kühleinheit an oder anstelle einer Gehäusetür erlaubt einen einfachen, modularen Aufbau des Gehäuseracks, wobei die Kühleinheit in räumlicher Nähe und in Strömungsrichtung direkt vor den zu kühlenden Einschubkomponenten angeordnet ist.

Gemäß einer weiteren vorteilhaften Ausgestaltung ist die Kühlanordnung durch wenigstens zwei Temperatursensoren zum Erfassen einer ersten Temperaturdifferenz der zur Kühlung verwendeten Luft und eine Steuervorrichtung zur Steuerung einer Lüfterdrehzahl der Ablufteinheit gekennzeichnet. Dabei ist die Steuervorrichtung dazu eingerichtet, die Ablufteinheit in Abhängigkeit einer Energieaufnahme der Ablufteinheit und einer Energieaufnahme der Kühleinheit unter Berücksichtigung der ersten Temperaturdifferenz anzusteuern. Eine derartige Kühlanordnung gestattet den Aufbau eines geschlossenen Regelkreises für die Kühlanordnung, wobei die Energieaufnahme und Auswirkungen der einzelnen Kühlkomponenten aufeinander abgestimmt werden können. Weitere vorteilhafte Ausgestaltungen sind in der nachfolgenden ausführlichen Beschreibung von Ausführungsbeispielen sowie den angehängten Patentansprüchen angegeben.

Die Erfindung wird nachfolgend anhand unterschiedlicher Ausführungsbeispiele unter Bezugnahme auf die angehängten Figuren näher beschrieben. In den Figuren zeigen:
- Figur 1: eine erste mögliche Kühlanordnung,
- Figur 2: ein Kühlmodell zur Bestimmung der Leistungsaufnahme einer Kühlanordnung,
- Figur 3: die Kühlleistung einer Kühlanordnung in Abhängigkeit einer Temperaturdifferenz,
- Figur 4: eine zweite mögliche Kühlanordnung,
- Figur 5: die Leistungsaufnahme eines Servereinschubs in Abhängigkeit einer Arbeitstemperatur.

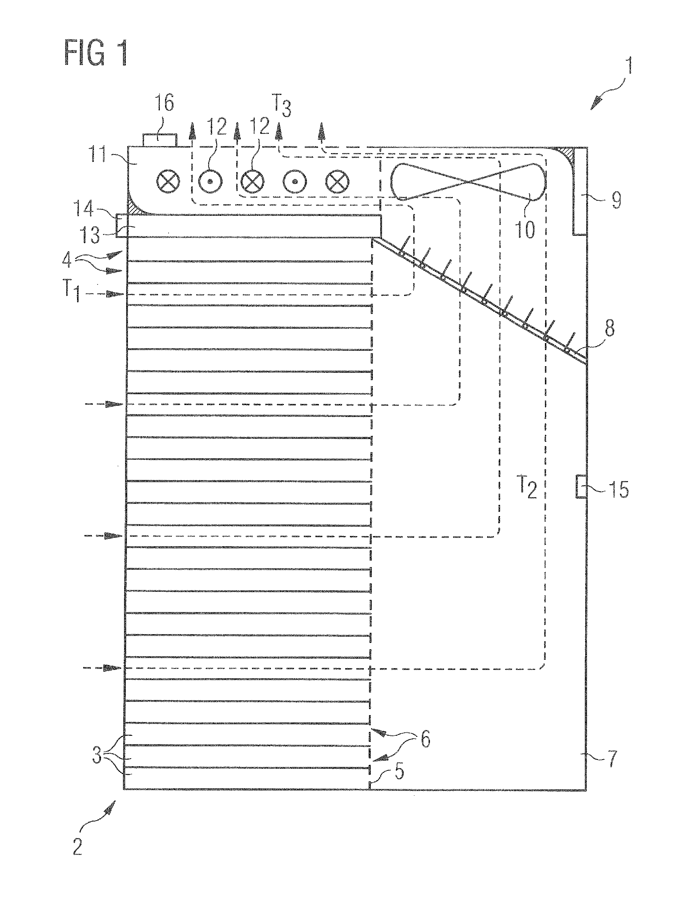

Figur 1 zeigt eine erste beispielhafte Kühlanordnung für ein Serverrack.

Die Kühlanordnung weist ein Rackgehäuse 1 zur Aufnahme einer Mehrzahl von Einschubkomponenten 3 auf. Im Ausführungsbeispiel sind die Einschubkomponenten 3 übereinander in Einschubpositionen 4 des Rackgehäuses 1 angeordnet. Die Einschubpositionen 4 sind von einer Vorderseite 2 des Rackgehäuses 1 her zugänglich. Bei den Einschubkomponenten 3 handelt es sich beispielsweise um Servereinschübe, die eine Hauptplatine mit darauf angeordneten Prozessoren und Speichermodulen aufweisen. Gemäß einer vorteilhaften Ausgestaltung umfassen die einzelnen Einschubkomponenten keine aktiven Kühlkomponenten. Insbesondere weisen die Einschubkomponenten 3 keine eigenen Lüfter zum Ansaugen von Kühlluft auf.

Um eine zentrale Kühlung sämtlicher Einschubkomponenten 3 in dem Rackgehäuse 1 zu ermöglichen, weist das Rackgehäuse des Weiteren eine Schottwand 5 mit Öffnungen 6 zwischen den einzelnen Einschubpositionen 4 und einer ebenfalls in dem Rackgehäuse 1 angeordneten Unterdruckkammer 7 auf. Zur Kühlung elektrischer oder elektronischer Bauteile der Einschubkomponenten 3 wird Umgebungsluft mit einer Temperatur T₁ durch die Einschubpositionen 4 und die Öffnungen 6 in der Schottwand 5 in die Unterdruckkammer 7 abgesaugt. Dabei sorgt die Größe der Öffnungen 6 für eine einfache Einstellung des benötigten Kühlluftstroms. Beispielsweise können einzelne Öffnungen 6 verschlossen werden, wenn in der zugehörigen Einschubpositionen 4 keine Einschubkomponente 3 angeordnet ist.

Die erwärmte Kühlluft wird aus der Unterdruckkammer 7 durch Rückschlaggitter 8 von einer Ablufteinheit 9 abgesaugt. Die Ablufteinheit 9 weist im Ausführungsbeispiel zwei in der Schnittdarstellung der Figur 1 hintereinander angeordnete Lüfter 10 auf, wobei jedem Lüfter ein eigenes Rückschlaggitter 8 zugeordnet ist, um eine Absaugöffnung bei Ausfall eines der Lüfter 10 zu verschließen. Im Ausführungsbeispiel handelt es sich bei den Lüftern 10 um Radialventilatoren, die die nach oben gesaugte Kühlluft nach vorne in eine Kühleinheit 11 mit einem darin angeordneten Wärmetauscher 12 abblasen. Bei dem Wärmetauscher 12 handelt es sich beispielsweise um eine Kühlschlange, die von einem flüssigen Kühlmittel durchströmt wird.

Der Wärmetauscher 12 überträgt die Energie der erwärmten Luft mit einer Temperatur T2 auf das flüssige Kühlmittel, so dass die Luft nach Durchlaufen der Kühleinheit 11 an der Oberseite des Rackgehäuses 1 mit einer Temperatur T₃ austritt. Bevorzugt entspricht die Temperatur T₃ der Temperatur T₁ der angesaugten Umgebungsluft.

Die Drehzahl des Lüfters 10 sowie gegebenenfalls eine Regelung der Temperatur und/oder der Strömungsgeschwindigkeit des Kühlmittels in der Kühleinheit 11 werden durch eine zentrale Steuervorrichtung 13 vorgegeben. Zur Sicherstellung einer ausreichenden Kühlung ist die Steuervorrichtung 13 im Ausführungsbeispiel mit einem ersten Temperatursensor 14 und einem zweiten Temperatursensor 15 verbunden. Der erste Temperatursensor ist im Bereich der Vorderseite 2 des Rackgehäuses 1 angeordnet und bestimmt im Wesentlichen die Temperatur T₁ der angesaugten Umgebungsluft. Der zweite Sensor 15 ist in der Unterdruckkammer 7 angeordnet und bestimmt im Wesentlichen die Temperatur T₂ der erwärmten Kühlluft. Die Steuervorrichtung 13 kann des Weiteren mit einem optionalen dritten Temperatursensor 16 im Bereich des Luftaustritts der Kühleinheit 11 verbunden sein. Des Weiteren kann die Steuervorrichtung 13 auch weitere Eingangsparameter, wie beispielsweise den absoluten oder relativen Unterdruck in der Unterdruckkammer 7, sowie die Leistungsaufnahme oder Temperatur einzelner Einschubkomponenten 3 erfassen und bei der Ansteuerung des Lüfters 10 berücksichtigen.

Die Steuervorrichtung 13 ist dazu eingerichtet, die Lüfterdrehzahl des Lüfters 10 so zu regeln, dass die Energieaufnahme der Ablufteinheit 9 und der Kühleinheit 11 in Kombination möglichst gering ist. Dabei muss selbstverständlich eine ausreichende Kühlung für die einzelnen Einschubkomponenten 3 sichergestellt werden.

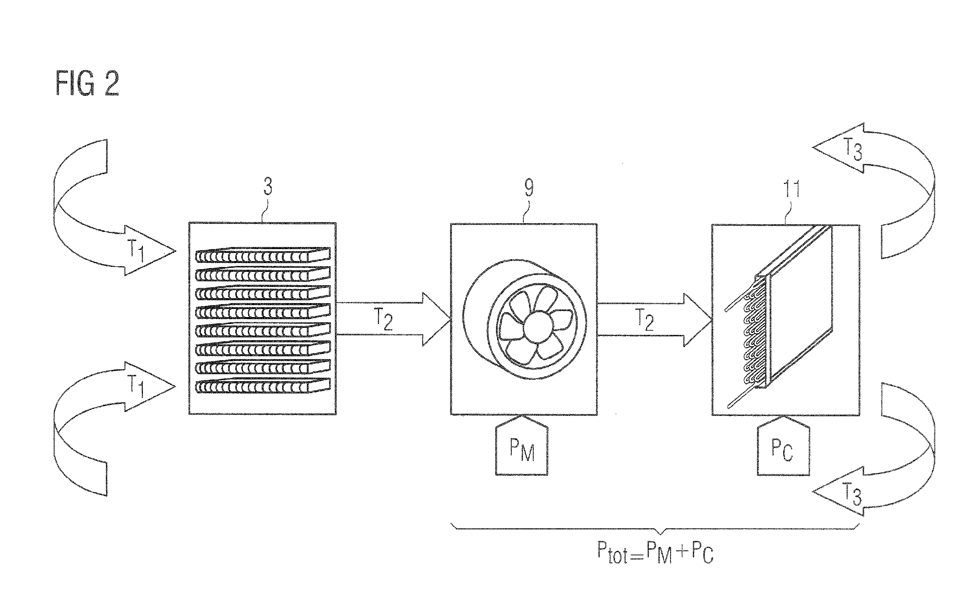

Figur 2 zeigt ein für die Optimierung der Leistungsaufnahme der beschriebenen Kühlanordnung verwendetes Modell. Wie aus der Figur 2 ersichtlich ist, wird Umgebungsluft mit einer ersten Temperatur T₁ durch eine Mehrzahl von Einschubkomponenten 3, beispielsweise Servereinschübe für eine Rackanordnung, gesaugt. Die angesaugte Umgebungsluft dient dabei zur Kühlung elektrischer oder elektronischer Bauteile, die beispielsweise auf einer Platine der Einschubkomponente 3 angeordnet sind. Die Kühlung der elektrischen oder elektronischen Bauteile führt zugleich zu einer Erwärmung der angesaugten Umgebungsluft, die nach Durchströmen den Einschubkomponenten gemäß dem in der Figur 2 dargestellten Modell eine Temperatur T₂ aufweist.

Die erwärmte Luft wird im in der Figur 2 dargestellten Schema durch eine Ablufteinheit 9 angesaugt, die beispielsweise einen Lüfter 10 oder eine ähnliche Fördereinrichtung aufweist. Zum Ansaugen der zur Kühlung verwendeten Luft nimmt die Ablufteinheit 9 eine elektrische Leistung P_{M} zum Betrieb des Lüfters 10 auf.

Um die von der Ablufteinheit ausgestoßene Kühlluft mit der Temperatur T₂ wieder auf das Niveau der Umgebungsluft abzukühlen, wird im in der Figur 2 dargestellten Modell eine Kühleinheit 11 eingesetzt. Die Kühleinheit 11 nimmt eine weitere Leistung P_{c} zum Abkühlen der erwärmten Umgebungsluft aus. Nach Durchströmen der Kühleinheit besitzt die zur Kühlung eingesetzte Luft eine gegenüber der zweiten Temperatur T₂ verminderte Temperatur T₃, die im Falle einer umgebungsneutralen Kühlanordnung der ersten Temperatur T₁ entspricht.

Gemäß dem in der Figur 2 dargestellten Modell beträgt die Gesamtleistungsaufnahme zur Kühlung des Serverracks Pₜₒₜ der Summe der Einzelleistungen P_{M} und P_{c}.

Die Energieeffizienz der einzelnen Komponenten, hier insbesondere der Ablufteinheit 9 und der Kühleinheit 11, werden durch verschiedene Faktoren bestimmt.

Im Falle der Ablufteinheit 9 wird die Energieeffizienz durch die Effizienz eines Lüftermotors, die Gehäusegeometrie des Rackgehäuses 1 und durch einen Volumenstrom V der Kühlluft bestimmt. In dem beschriebenen Ausführungsbeispiel beträgt die Energieaufnahme der Ablufteinheit 9 beispielsweise P_{M} = k₁ x V^{m}, wobei k₁ eine gehäusespezifische Konstante darstellt und m eine Konstante für die Effizienz des eingesetzten Lüftermotors darstellt.

Der Volumenstrom V, der zur Kühlung der Einschubkomponenten 3 benötigt wird, ist umgekehrt proportional zu der Temperaturdifferenz zwischen der erwärmten Luft mit der Temperatur T₂ und der Umgebungsluft mit der Temperatur T₁. Es gilt V = k₂ ÷ (T₂ - T₁). Hierbei stellt die Konstante k₂ wiederum eine für die Gehäusegeometrie des verwendeten Rackgehäuses 1 typische Konstante dar.

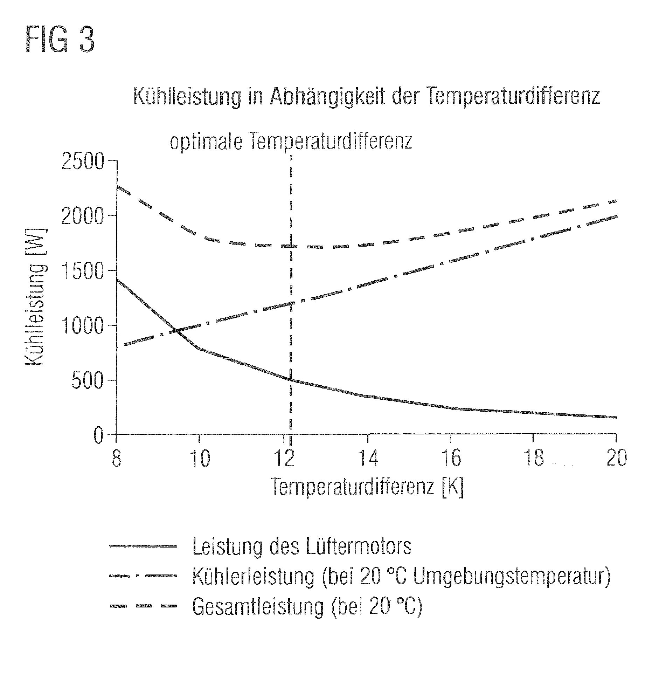

Mit den Werten k₁ = 28.000, k₂ = 10⁻⁶ und m = 2,5 ergibt sich die in der Figur 3 mit durchgezogener Linie dargestellte Leistungsaufnahme der Ablufteinheit 9 in Abhängigkeit der Temperaturdifferenz ΔT = T₂ - T₁. Der Figur 3 ist zu entnehmen, dass die Leistungsaufnahme P_{M} mit geringerer Temperaturdifferenz ΔT stark ansteigt. Umgekehrt fällt die Leistungsaufnahme P_{M} der Ablufteinheit mit steigender Temperaturdifferenz ΔT ab.

Die von der Kühleinheit 11 aufgenommene Leistung P_{c} hängt stark von der jeweils verwendeten Kühltechnologie ab. Reicht die Umgebungsluft und natürliche Wärmedissipation zur Kühlung der Einschubkomponenten 3 aus, nimmt die Kühleinheit 11 überhaupt keine Energie auf. In den hier relevanten Fällen von Rackanordnungen mit einer Vielzahl von Einschubkomponenten 3 wird jedoch in der Regel eine aktive Kühleinheit 11 verwendet, deren Energieaufnahme wie folgt dargestellt werden kann: P_{c} = Q x (T₂ - T) ÷ (T₁ x E). Dabei entspricht Q der thermischen Energie, die durch die Kühleinheit 11 abgeführt wird. Der Wert E entspricht der relativen Energieeffizienz der eingesetzten Kühltechnologie. Bei einem Wärmetauscher 12 beträgt der Wert für E beispielsweise 0,5.

Wie sich aus Messungen ergeben hat, ist die Abhängigkeit von der absoluten Umgebungstemperatur T₁ für in der Praxis auftretende Werte von beispielsweise 15 bis 25 °C unerheblich gegenüber den anderen, die Energieaufnahme P_{c} beeinflussende Faktoren. In der Figur 3 ist daher lediglich die Leistungsaufnahme bei einer Lufteinlasstemperatur von 20 °C dargstellt. Auch hier spielt jedoch die Temperaturdifferenz ΔT = T₂ - T₁ eine wesentliche Rolle für die Energieaufnahme der Kühleinheit 11 insgesamt. Gemäß der Strichpunktlinie der Figur 3 steigt die Energieaufnahme P_{c} der Kühleinheit 11 mit steigender Temperaturdifferenz ΔT im Wesentlichen linear an.

In der Figur 3 ist die kombinierte Leistungsaufnahme Pₜₒₜ der Ablufteinheit 9 und der Kühleinheit 11 gestrichelt dargestellt. Wie sich aus der Figur 3 ergibt, weist die Kurve im mittleren Bereich ein Minimum auf, das der geringsten Gesamtenergieaufnahme Pₜₒₜ entspricht. Für größere Temperaturdifferenzen ΔT = T₂ - T₁ steigt die Energieaufnahme wegen dem steigenden Energiebedarf der Kühleinheit 11 an. Für niedrigere Temperaturdifferenzen ΔT steigt die Energieaufnahme wegen der stark ansteigenden Leistungsaufnahme der Ablufteinheit 9 an.

Im zuvor beschriebenen Ausführungsbeispiel mit den oben angegebenen Konstanten ergibt sich ein Minimum für eine Temperaturdifferenz ΔT von 12 °C zwischen einer Temperatur T₁ der Umgebungsluft und einer Temperatur T₂ nach Erwärmung der Umgebungsluft durch die zu kühlenden Komponenten.

Bevorzugt bestimmt die Steuereinrichtung 13 die Temperaturen T1, T2 und T3 und regelt den Lüftermotor so an, dass die von der Kühlanordnung abgegebene Luft nicht oder um nicht mehr als einen vorgegebenen Grenzwert wärmer ist als die angesaugte Umgebungsluft und zugleich die bestimmte, optimale Temperaturdifferenz ΔT eingehalten wird.

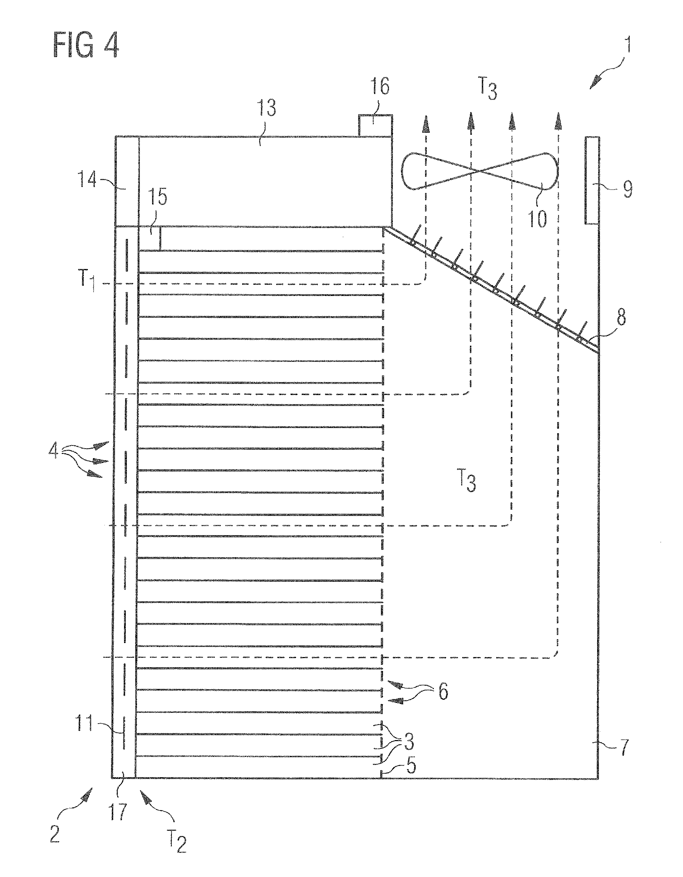

Um die Effizienz der beschriebenen Rackanordnung noch weiter zu verbessern, wurde die Kühleinheit 11 gemäß einem zweiten Ausführungsbeispiel, das in der Figur 4 dargestellt ist, in Strömungsrichtung vor die zu kühlenden Einschubkomponenten 3 verlagert. Beispielsweise kann die Kühleinheit 11 als Teil einer Gehäusetür 17 ausgestaltet werden. Wegen der verhältnismäßig großen Fläche der Gehäusetür 17 kann die Kühleinheit 11 sehr dünn ausgelegt werden, so dass auch nur ein verhältnismäßig geringer Raumbedarf entsteht. In diesem Fall kann die Luft aus der Unterdruckkammer 7 ungehindert durch den Lüfter 10 nach oben abgegeben werden.

Im Ergebnis wird die zur Kühlung verwendete Umgebungsluft jetzt zuerst gegenüber der Temperatur T₁ der Umgebungsluft auf die Temperatur T₂ abgekühlt und nachfolgend durch die Einschubkomponenten 3 auf die Temperatur T₃ aufgewärmt, beispielsweise wieder auf die Temperatur T₁ der Umgebungsluft.

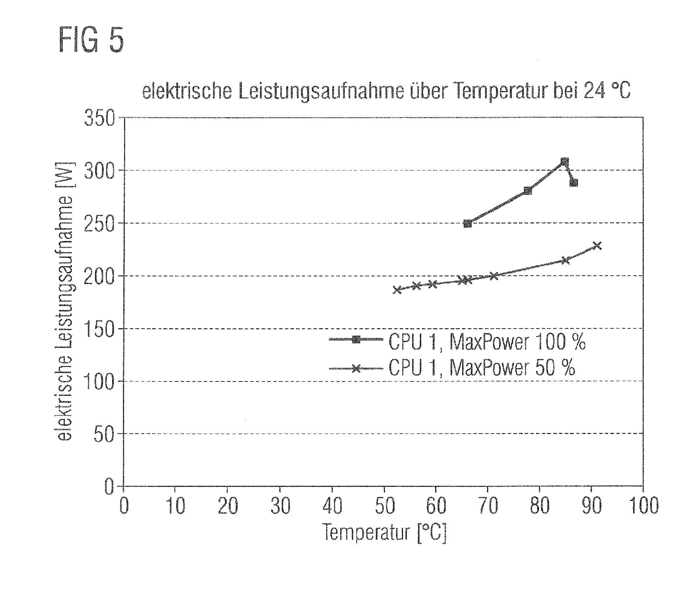

Der Vorteil einer derartigen Kühlanordnung ergibt sich insbesondere aus der Figur 5. In der Figur 5 ist die elektrische Leistungsaufnahme eines Servereinschubs 3, der innerhalb einer Einschubposition 4 angeordnet ist, über seiner Arbeitstemperatur angegeben. Dabei wird die Arbeitstemperatur des Prozessors beispielsweise über einen chipinternen Temperatursensor erfasst. In Abhängigkeit der Auslastung des Prozessors steigt dessen Kerntemperatur an. Die elektrische Leistungsaufnahme steigt des Weiteren mit zunehmender Chiptemperatur an, weil die in dem Halbleiterbaustein auftretenden Leckströme sich vergrößern.

Bei Auslastung des Prozessors mit einer Arbeitsbelastung von 50 Prozent steigt die elektrische Leistungsaufnahme eines Servereinschubs beispielsweise von etwa 190 auf etwa 230 Watt bei einer Chiptemperatur von 50 bis 90 °C an. Dabei ist die Chiptemperatur im Wesentlichen abhängig von dem Volumenstrom V der zur Kühlung verwendeten Luft, die im Ausführungsbeispiel eine Temperatur von 24 °C aufweist. Wird der Luftstrom geringer, erhöht sich die Temperatur der Chips des Servereinschubs weiter und deren Leistungsaufnahme steigt an. Wird der Luftstrom vergrößert, sinkt die Temperatur der Prozessoren und deren Leistungsaufnahme fällt ab.

Noch drastischer ist der Effekt bei einem voll ausgelasteten Prozessor, wie dies im oberen Teil der Figur 5 dargestellt ist. Bei einer Vollauslastung des Prozessors und einem gleichzeitigen, verhältnismäßig geringen Volumenstrom V einer Kühlluft erreicht der Servereinschub schließlich eine Leistungsaufnahme von mehr als 300 Watt, bei der ein interner Schutzmechanismus des Prozessors dessen Arbeitstakt drosselt. Infolgedessen sinkt die Leistungsaufnahme des Servereinschubs leicht ab, wobei dies jedoch gleichzeitig mit einem Verlust an Rechenleistung einhergeht. Trotz fallender absoluter Leistungsaufnahme verringert sich die Energieeffizienz der Anordnung insgesamt.

Wie sich aus der Figur 5 ergibt, ist die Leistungsaufnahme von Prozessoren und anderen Halbleiterchips geringer, wenn die Temperatur der Chips reduziert werden kann. Zu diesem Zweck wird in dem Ausführungsbeispiel gemäß Figur 4 die Umgebungsluft zuerst abgekühlt, bevor diese zur Kühlung der Einschubkomponenten 3 verwendet wird.

Wird in der Kühlanordnung gemäß Figur 1 beispielsweise eine Kühleinheit 11 eingesetzt, die die Temperatur der sie durchströmenden Luft um 11 °C vermindert, werden die einzelnen Bauteile der Einschubkomponenten 3 mit einer Kühlluft, die die erste Temperatur T₁ aufweist angeströmt. Beispielsweise handelt es sich bei der Temperatur T₁ um eine Umgebungstemperatur von 25 °C. Durch die Komponenten wird die Umgebungsluft auf eine Temperatur T₂ von beispielsweise 36 °C erwärmt und nachfolgend durch die Kühleinheit 11 wieder auf die Umgebungstemperatur von 25 °C abgekühlt. Je nach Anordnung der einzelnen Bauteile in den Einschubkomponenten 3 werden diese daher mit einer Kühlluft mit einer Temperatur zwischen 25 und 36 °C umgeben.

Gemäß der Ausführung der Kühlanordnung nach Figur 4 wird die zur Kühlung verwendete Umgebungsluft jedoch zunächst um 11 °C abgekühlt, so dass sie mit einer Temperatur von etwa 14 °C in die einzelnen Einschubkomponenten 3 eintritt. Bei Austritt der zur Kühlung verwendeten Luft aus den Einschubkomponenten 3 in die Unterdruckkammer 7 weist sie wiederum eine Temperatur von 25 °C aus, die beispielsweise der Temperatur der Umgebungsluft entspricht. In diesem Fall werden die einzelnen Bauelemente der Einschubkomponenten 3 mit einer Temperatur von beispielsweise 14 bis 25 °C umgeben, so dass deren Leckstromverluste geringer sind.

Die beschriebenen Überlegungen und Konzepte zur Verbesserung der Kühleffizienz von Rackanordnungen ergänzen sich einander, wobei zum Einen durch die vorteilhafte Anordnung der Kühleinheit 11 in Strömungsrichtung vor den zu kühlenden Einschubkomponenten 3 die Verlustleistung der einzelnen Bauteile der Einschubkomponenten 3 reduziert wird und zum anderen durch eine kombinierte Berücksichtigung der Leistungsaufnahme der Ablufteinheit 9 und der Kühleinheit 11 die Leistungsaufnahme des Kühlsystems insgesamt reduziert wird.

Obwohl das Kühlsystem unter Bezugnahme auf ein Serverrack als Ausführungsbeispiel beschrieben wurde, eignet sich die beanspruchte Kühlanordnung und das Arbeitsverfahren auch für andere Computersysteme. Beispielsweise eignen sich die beschriebenen Vorrichtungen und Verfahren auch für leistungsfähige Einzelserver mit einer Mehrzahl von Einzelkomponenten wie beispielsweise Laufwerken, Speichermodulen und Prozessoren oder für so genannte Blade-Server mit einer Mehrzahl von Prozessor- und sonstigen Einschüben in einem gemeinsamen Gehäuse.

### Bezugszeichenliste

- 1: Rackgehäuse
- 2: Vorderseite
- 3: Einschubkomponente
- 4: Einschubposition
- 5: Schottwand
- 6: Öffnung
- 7: Unterdruckkammer
- 8: Rückschlaggitter
- 9: Ablufteinheit
- 10: Lüfter
- 11: Kühleinheit
- 12: Wärmetauscher
- 13: Steuervorrichtung
- 14: erster Temperatursensor
- 15: zweiter Temperatursensor
- 16: dritter Temperatursensor
- 17: Gehäusetür

## Patentansprüche

1. Arbeitsverfahren für eine Lüftersteuerung einer Kühlanordnung mit wenigstens einer Ablufteinheit (9) zum Absaugen von durch elektrische oder elektronische Bauteile einer Mehrzahl von Einschubkomponenten (3) erwärmte Luft und wenigstens einer Kühleinheit (11) zum Kühlen der zur Kühlung verwendeten Luft, aufweisend die Schritte:
- Bestimmen einer optimierten Temperaturdifferenz für die zur Kühlung des Serverracks verwendete Luft unter Berücksichtigung der Energieaufnahme der wenigstens einen Ablufteinheit (9) und der wenigstens einen Kühleinheit (11) in Abhängigkeit der Temperaturdifferenz;
- Messen wenigstens einer tatsächlichen Temperaturdifferenz zwischen wenigstens zwei Temperaturen der zur Kühlung verwendeten Luft; und
- Regeln einer Lüfterdrehzahl für die wenigstens eine Ablufteinheit (9) in Abhängigkeit einer Abweichung zwischen der bestimmten optimierten Temperaturdifferenz und der gemessenen tatsächlichen Temperaturdifferenz.

2. Arbeitsverfahren nach Anspruch 1,
**dadurch gekennzeichnet, dass**
im Schritt des Messens wenigstens eine erste Temperaturdifferenz der zur Kühlung verwendeten Luft vor und nach einem Durchströmen der elektrischen oder elektronischen Bauteile gemessen wird.

3. Arbeitsverfahren nach Anspruch 2,
bei dem Luft aus einer Umgebung der Kühlanordnung zur Kühlung verwendet wird und die erste Temperaturdifferenz die Differenz zwischen einer Temperatur einer
Umgebungsluft und einer Temperatur der durch die elektrischen oder elektronischen Bauteile erwärmten Luft ist.

4. Arbeitsverfahren nach einem der Ansprüche 1 bis 3,
**dadurch gekennzeichnet, dass**
im Schritt des Messens wenigstens eine zweite Temperaturdifferenz der zur Kühlung verwendeten Luft vor und nach einem Durchströmen der Kühleinheit (11) gemessen wird.

5. Arbeitsverfahren nach Anspruch 4,
bei dem die zur Kühlung verwendete Luft nach dem Durchströmen der Kühleinheit (11) an eine Umgebung der Kühlanordnung abgegeben wird und die zweite Temperaturdifferenz die Differenz zwischen einer Temperatur einer durch die elektrischen oder elektronischen Bauteile erwärmten Luft ist und einer Temperatur einer Umgebungsluft ist.

6. Kühlanordnung, aufweisend:
- ein Gehäuse mit einer Mehrzahl von Einschubpositionen (4) zur Aufnahme von Einschubkomponenten (3),
- wenigstens eine Ablufteinheit (9) zum Absaugen von durch elektrische oder elektronische Bauteile der Einschubkomponenten (3) erwärmter Luft und
- wenigstens eine Kühleinheit (11) zum Abkühlen der zur Kühlung verwendeten Luft,
**dadurch gekennzeichnet, dass**
- die Kühleinheit (11) in Strömungsrichtung vor der Mehrzahl der Einschubpositionen (4) angeordnet ist, so dass in den Einschubpositionen (4) angeordnete Einschubkomponenten (3) mit gegenüber einer Temperatur einer bereitgestellten Luft abgekühlter Luft angeströmt werden.

7. Kühlanordnung nach Anspruch 6,
**dadurch gekennzeichnet, dass**
die Kühlanordnung ein offenes Kühlsystem bildet, bei der Luft aus einer Umgebung des Gehäuses im Bereich der Kühleinheit (11) angesaugt und durch die Ablufteinheit (9) an die Umgebung abgegeben wird.

8. Kühlanordnung nach Anspruch 6 oder 7,
**dadurch gekennzeichnet, dass**
die wenigstens eine Kühleinheit (11) einen Wärmetauscher (12) aufweist, wobei der Wärmetauscher (12) die von der Kühleinheit (11) entnommene Wärmeenergie an ein flüssiges Kühlmedium überträgt.

9. Kühlanordnung nach einem der Ansprüche 6 bis 7,
**dadurch gekennzeichnet, dass**
das Gehäuse als Rackgehäuse (1) für ein Serverrack mit der Mehrzahl von Einschubpositionen (4) zur Aufnahme einer Mehrzahl von Einschubservern ausgebildet ist, wobei das Rackgehäuse (1) eine für alle Einschubpositionen (4) zentrale Kühlluftführung aufweist, die mindestens jeweils eine Öffnung (6) zum Absaugen der erwärmten Luft aus den Einschubpositionen (4) mit der wenigstens einen Ablufteinheit (9) verbindet.

10. Kühlanordnung nach Anspruch 9,
**dadurch gekennzeichnet, dass**
die zentrale Kühlluftführung eine Unterdruckkammer (7) aufweist, wobei die wenigstens eine Ablufteinheit (9) dazu eingerichtet ist, einen gegenüber einem Umgebungsluftdruck reduzierten Unterdruck in der Unterdruckkammer (7) herzustellen.

11. Kühlanordnung nach einem der Ansprüche 9 oder 10,
**dadurch gekennzeichnet, dass**
die Kühleinheit (11) an oder anstelle einer vor der Mehrzahl von Einschubpositionen (4) angeordneten Gehäusetür (17) des Rackgehäuses (1) angeordnet ist.

12. Kühlanordnung nach einem der Ansprüche 6 bis 11,
**gekennzeichnet durch**:
- wenigstens zwei Temperatursensoren (14, 15, 16) zum Erfassen einer Temperaturdifferenz der zur Kühlung verwendeten Luft und
- eine Steuervorrichtung (13) zur Steuerung einer Lüfterdrehzahl der Ablufteinheit (9), wobei die Steuervorrichtung dazu eingerichtet ist, die Ablufteinheit (9) in Abhängigkeit der Energieaufnahme der Ablufteinheit (9) und der Energieaufnahme der Kühleinheit (11) unter Berücksichtigung der Temperaturdifferenz anzusteuern.
